(19) **Europäisches Patentamt**

**European Patent Office**

**Office européen des brevets**

(11) **EP 1 549 963 B1**

(12) **FASCICULE DE BREVET EUROPEEN**

(45) Date de publication et mention
de la délivrance du brevet:
**07.06.2006 Bulletin 2006/23**

(51) Int Cl.:
***G01R 31/02*** *(2006.01)*     ***G01R 31/04*** *(2006.01)*
***G01R 29/10*** *(2006.01)*

(21) Numéro de dépôt: **03798131.3**

(22) Date de dépôt: **27.08.2003**

(86) Numéro de dépôt international:
**PCT/EP2003/009454**

(87) Numéro de publication internationale:
**WO 2004/029639 (08.04.2004 Gazette 2004/15)**

(54) **PROCEDE DE DIAGNOSTIQUE CONCERNANT LE BRANCHEMENT D'UNE ANTENNE**

DIAGNOSEVERFAHREN FÜR EINE ANTENNENVERBINDUNG

DIAGNOSIS METHOD FOR AN ANTENNA CONNECTION

(84) Etats contractants désignés:
**DE**

(30) Priorité: **30.09.2002 FR 0212084**

(43) Date de publication de la demande:
**06.07.2005 Bulletin 2005/27**

(73) Titulaire: **Siemens VDO Automotive**
**31036 Toulouse Cedex 1 (FR)**

(72) Inventeur: **ROCHER, Jacques**
**F-31650 Saint-Orens (FR)**

(56) Documents cités:
**DE-A- 19 820 207**     **US-A- 5 371 508**

**Description**

La présente invention concerne un procédé de diagnostic concernant le branchement d'une antenne, notamment une antenne utilisée pour l'émission de signaux basse fréquence dans un véhicule automobile.

Dans un véhicule automobile, il est connu d'utiliser une antenne basse fréquence (ou LF pour Low Frequency) pour dialoguer avec un badge extérieur ou bien encore pour la surveillance de la pression des pneumatiques.

Dans le premier cas, on suppose que le véhicule est équipé d'un système mains libres permettant d'accéder à son véhicule et éventuellement de le démarrer sans avoir à utiliser de clé mécanique. L'utilisateur du véhicule est alors simplement muni d'un badge qui est détecté et reconnu par un dispositif de commande et de gestion associé à des antennes disposées à bord du véhicule. Si le badge est identifié par le dispositif de commande et de gestion comme étant un badge autorisé pour le véhicule, le porteur de ce badge peut pénétrer à l'intérieur du véhicule en saisissant simplement une poignée de portière et éventuellement démarrer le moteur du véhicule par simple action sur un bouton.

Pour un tel système mains libres, plusieurs antennes LF sont prévues. Chaque antenne est pilotée par un dispositif appelé driver, ce dernier pilotant éventuellement plusieurs antennes. Généralement, on compte quatre drivers dans un véhicule équipé d'un système d'accès (et éventuellement démarrage) mains libres : un driver pour les antennes situées à l'extérieur du véhicule sur le côté gauche de celui-ci, un pour les antennes extérieures situées à droite, un pour les antennes extérieures situées à l'arrière du véhicule et un dernier pour les antennes situées à l'intérieur du véhicule.

Dans certains véhicules équipés d'un système de surveillance de la pression des pneus (SSPP), une antenne LF se trouve à proximité de chaque roue du véhicule. Ces antennes sont alors chacune pilotées par un driver, lui-même relié à un calculateur disposé à bord du véhicule.

Un problème qui se pose lors du montage d'un système mains libres ou d'un système de surveillance de la pression des pneumatiques est de s'assurer que chaque antenne est bien reliée à son driver. Ce dernier est en général intégré à un calculateur de commande et de gestion à l'intérieur de l'habitacle du véhicule.

Le document DE-198 20 207 décrit un dispositif de diagnostic pour une antenne. Le diagnostic est réalisé en mesurant une inductivité. Un signal est envoyé à l'antenne et on mesure le déphasage entre le signal d'excitation et la tension de résonance induite par cette excitation. Le procédé mis alors en oeuvre pour vérifier le bon branchement d'une antenne est relativement long et complexe. En effet, les résultats ne sont pas les mêmes si une ou plusieurs antennes sont connectées à un même driver. De plus, un matériel spécifique est nécessaire pour la mise en oeuvre de ce procédé.

La présente invention a alors pour but de fournir un procédé simple à mettre en oeuvre permettant de détecter la présence et le bon raccordement d'une antenne à son dispositif de commande. Ce procédé permet de préférence de détecter si l'antenne contrôlée présente ou non un court-circuit à la masse.

A cet effet, elle propose un procédé de diagnostic concernant la connexion d'une antenne comportant une bobine ou similaire reliée d'une part à un potentiel de référence et d'autre part à une sortie d'un amplificateur, un premier condensateur étant monté en parallèle à la bobine et un second condensateur étant inséré entre une borne de la bobine et le potentiel de référence.

Selon l'invention, ce procédé comporte les étapes suivantes :

a) émission d'un signal par l'amplificateur,
b) première mesure de la tension à une borne de l'antenne durant le régime transitoire provoqué par l'émission du signal, et
c) seconde mesure de la tension à la même borne de l'antenne en régime stabilisé.

Alors qu'habituellement les mesures sont réalisées en régime stabilisé, il est proposé ici de faire une mesure en régime transitoire. Cette première mesure permet de donner des indications sur le montage de l'antenne et sa connexion. Si seule la deuxième mesure est réalisée, on ne peut détecter si l'antenne est connectée ou non. Certes la tension mesurée en régime stabilisé est faible dans le premier cas tandis que lorsque l'antenne est déconnectée, la tension mesurée est relativement élevée car le premier condensateur est alors chargé. Toutefois, si l'antenne est connectée mais présente un court-circuit à la masse, la seconde mesure effectuée seule donnera comme résultat que la connexion est réalisée et bonne. La première mesure durant le régime transitoire permet de distinguer alors le cas où l'antenne est correctement connectée du cas où elle présente un court-circuit à la masse. Dans le premier cas, la première mesure donne une tension élevée tandis que dans le second cas la tension mesurée lors de cette première mesure est proche de zéro.

Un procédé de diagnostic selon l'invention peut par exemple être réalisé à la mise sous tension de l'antenne.

De préférence, le signal émis par l'amplificateur pour réaliser le diagnostic n'est pas modulé.

Le signal en sortie d'amplificateur est par exemple un signal du type présentant un temps de montée puis une durée d'impulsion et enfin un temps de descente. Dans ce cas de figure, la première mesure est de préférence réalisée durant le temps de montée, par exemple dans la seconde moitié de la montée du signal. Cette première mesure peut également être effectuée en tout début de la durée d'impulsion. Quant à la seconde mesure, elle est par exemple réalisée au cours de la durée d'impulsion.

Le procédé selon l'invention peut aussi être adapté au diagnostic de plusieurs antennes. Chaque antenne est alors par exemple connectée à un étage d'entrée d'un multiplexeur et une résistance disposée entre l'antenne et l'étage d'entrée du multiplexeur limite le courant dans l'étage d'entrée correspondant du multiplexeur.

D'autres détails et avantages de la présente invention ressortiront de la description qui suit, faite en référence au dessin schématique annexé sur lequel :

La figure 1 est une vue schématique de principe d'un montage pour la mise en oeuvre d'un procédé selon l'invention,

La figure 2 est un schéma électrique correspondant au montage de la figure 1 associé à un circuit de lecture,

La figure 3 est un diagramme représentant la forme du signal envoyé à l'antenne pour contrôler son branchement,

La figure 4 est un diagramme montrant la forme des différents signaux lorsque l'antenne est correctement connectée,

La figure 5 correspond à la figure 4, avec une échelle de temps différente, lorsque l'antenne n'est pas connectée, et

La figure 6 correspond à la figure 5 pour une antenne connectée mais présentant un court-circuit à la masse.

La description qui est faite ci-après se réfère à une antenne montée sur un véhicule automobile et destinée à être utilisée dans un système mains libres permettant ainsi au porteur d'un badge d'accéder à l'intérieur du véhicule et éventuellement de démarrer celui-ci sans utiliser de clé mécanique. Un tel système est connu de l'homme du métier et n'est pas décrit dans le détail ici.

On considérera par la suite une antenne de type LF (pour Low Frequency ou basse fréquence) destinée à émettre des signaux à une fréquence de 125 kHz. Bien entendu, l'invention peut également s'appliquer à une antenne émettant des signaux de fréquences différentes et pour d'autres applications.

De manière classique, un générateur de signaux sinusoïdaux (ici d'une fréquence de 125 kHz) fournit une porteuse à un modulateur. Ce dernier reçoit d'un dispositif de gestion et de commande les données devant être transmises par l'antenne et "assemble" le signal du générateur avec les données qu'il reçoit pour fournir le signal à émettre. Ce signal passe alors dans un dispositif amplificateur appelé couramment "driver" (qui signifie pilote en anglais). Tous ces divers éléments sont généralement disposés dans un même boîtier, ou calculateur, placé par exemple au niveau du tableau de bord d'un véhicule. Seule l'antenne est disposée à distance du boîtier. Cette antenne est par exemple intégrée à une poignée de portière ou de coffre du véhicule ou bien prend place à l'intérieur de l'habitacle de celui-ci. L'antenne est reliée au boîtier, ou calculateur, par l'intermédiaire d'un câble et de connecteurs. En général, plusieurs antennes correspondent à un même boîtier.

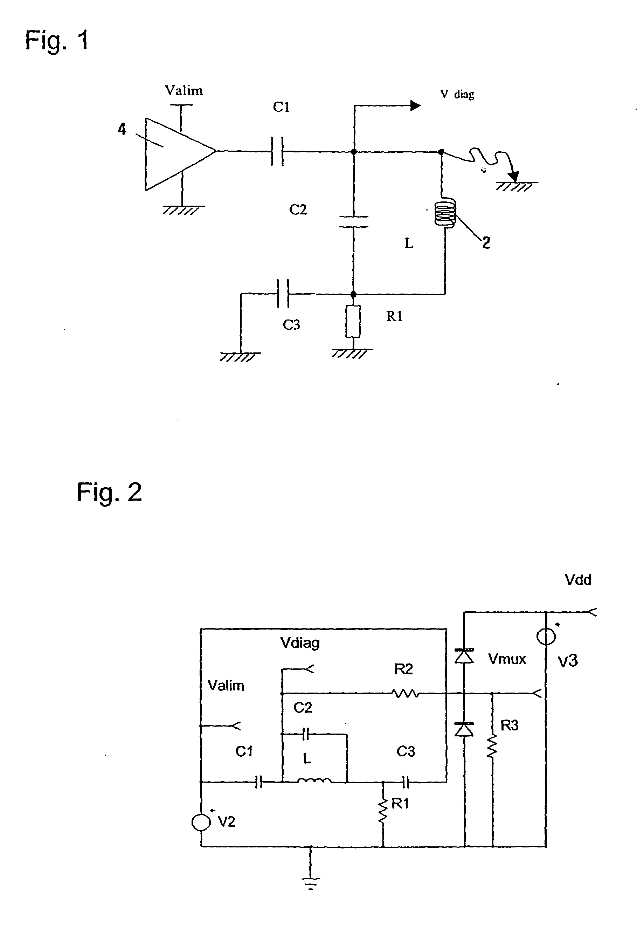

De nombreuses connexions doivent alors être effectuées. De la qualité de ces connexions dépend par la suite le bon fonctionnement du système mains libres. Il convient alors de vérifier en cours de montage si les connexions sont bien réalisées. Les figures 1 et 2 montrent un circuit de diagnostic permettant de contrôler facilement la présence (ou détecter l'absence) d'une antenne tout en s'assurant que cette dernière ne présente pas un court-circuit à la masse ou au plus.

La figure 1 montre schématiquement une bobine 2 correspondant à l'antenne dont il est question précédemment ainsi qu'un amplificateur de sortie 4 du driver pilotant cette antenne. On remarque également sur la figure 1 la présence de trois condensateurs C1, C2 et C3 ainsi que d'une résistance R1. Ces condensateurs et cette résistance, de même que l'amplificateur de sortie 4, se trouvent au niveau du calculateur, par exemple à l'intérieur de l'habitacle du véhicule, tandis que la bobine 2 se trouve à l'extérieur de ce calculateur.

L'amplificateur 4 est alimenté sous une tension Valim que l'on suppose par exemple égale à 24V. En sortie de cet amplificateur 4, se trouve le condensateur C1. Un tel condensateur est presque toujours présent en sortie d'amplificateur dans le cas d'un émetteur. Il est utilisé pour supprimer la composante continue du signal de sortie de l'amplificateur afin d'envoyer un signal purement alternatif à la bobine 2 émettrice.

Le condensateur C2 est monté quant à lui en parallèle avec la bobine 2 tandis que le condensateur C3 est monté en série entre le potentiel de référence et l'ensemble formant circuit résonnant et comportant le condensateur C2 et la bobine 2.

On retrouve ainsi, en sortie de l'amplificateur 4, les trois condensateurs C1, C2 et C3 montés en série tandis que la bobine 2 est montée en parallèle avec le condensateur C2.

Le condensateur C2 permet de réduire le courant en sortie d'amplificateur 4. Les signaux envoyés vers l'antenne ont une fréquence de 125kHz et le circuit résonnant formé par la bobine 2 d'inductance L et le condensateur C2 présente une forte impédance à cette fréquence.

Le condensateur C3 protège quant à lui l'antenne d'un éventuel court-circuit qui se produirait au plus de la batterie alimentant l'émetteur.

A titre d'exemple non limitatif, quelques valeurs numériques sont indiquées ci-après :

$$C1 = C3 = 1\ \mu F,$$

$$C2 = 37\ nF,$$

$$L = 38\ \mu H$$

$$R1 = 2{,}2\ k\Omega.$$

.

Sur la figure 2, on retrouve les mêmes éléments que ceux représentés sur la figure 1 et décrit ci-dessus. Un étage d'entrée d'un multiplexeur est également représenté sur la droite de cette figure. Ce dispositif est destiné à mesurer la tension Vdiag lue directement à la borne de la bobine 2 se trouvant du côté de l'amplificateur 4, c'est-à-dire la tension (signal analogique) régnant entre le condensateur C1 et la bobine 2. De façon classique, pour limiter le courant d'entrée dans le multiplexeur, une résistance R2 est prévue. Un tel étage d'entrée de multiplexeur est connu de l'homme du métier. Il comporte notamment une alimentation du circuit de lecture représenté par un générateur d'une tension V3. Des diodes sont prévues pour protéger le circuit logique de lecture. L'impédance d'entrée de ce circuit est symbolisée par une résistance R3. La tension donnée en sortie par ce circuit logique est appelé Vmux. Elle est l'image de la tension Vdiag mentionnée précédemment. L'utilisation d'un multiplexeur permet de limiter le nombre d'entrées/ sorties du microprocesseur utilisé pour la mesure.

A titre d'exemple numérique non limitatif, on a par exemple une tension d'alimentation Vdd de 5 V avec les résistances suivantes :
R2 = 47 kΩ et R3 = 100 MΩ

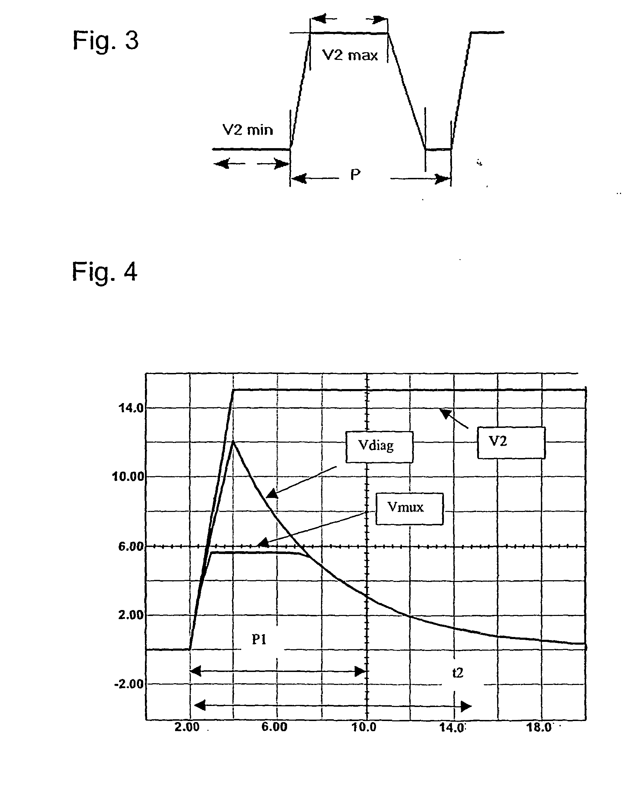

La figure 3 montre un exemple de signal pouvant alimenter la bobine 2 pour réaliser un diagnostic de branchement. Ce signal présente tout d'abord une valeur initiale, par exemple nulle. Cette période où la tension de sortie prend la valeur initiale est suivie d'un temps de montée pour arriver à une valeur maximale. Après une durée d'impulsion prédéterminée, suit un temps de descente pour revenir à la valeur initiale. Ce signal est par exemple un signal périodique de période P. A titre d'exemple numérique non limitatif, on peut par exemple avoir les valeurs suivantes :

Temps de montée : 2 ms,
Largeur d'impulsion : 40 ms,
Temps de descente : 80 ms,

Période : P = 124 ms, incluant une durée de 2 ms où le signal présente sa valeur initiale.
Valeur minimale = 0 V,
Valeur maximale = 15 V.

Le fonctionnement du dispositif de diagnostic est illustré sur les figures 4 à 6. Sur ces figures, on a représenté le signal V2 en sortie d'amplificateur, la tension Vdiag régnant à une borne de la bobine 2 ainsi que la tension Vmux mesurée par le circuit logique de mesure.

Sur la figure 4 on suppose que l'antenne est correctement connectée à son driver et qu'il n'y a donc aucun court-circuit. Les indications numériques portées en abscisse et en ordonnée sont données à titre purement indicatif. En abscisse les valeurs correspondent à des millisecondes tandis qu'en ordonnée il s'agit de Volts.

Quand l'antenne est correctement connectée, la bobine 2 court-circuite le condensateur C2. La résistance R1 est reliée à la masse. De ce fait le niveau de masse remonte au point où l'on mesure Vdiag. Pendant un régime transitoire, les capacités C1 et C3 se chargent à travers R1 puis C3 se décharge.

Ceci ressort de la figure 4 sur laquelle la tension Vdiag correspond à la charge du condensateur C3. La tension Vmux correspond à la tension Vdiag avec toutefois un écrêtage dû à la présence des diodes de protection de l'étage d'entrée du multiplexeur.

Le procédé de diagnostic selon la présente invention propose d'effectuer une première mesure à une date t1 à laquelle la tension Vmux est maximale ou présente une valeur proche de cette valeur maximale. Cette première mesure est donc effectuée durant le régime transitoire au cours duquel les capacités C1 et C3 se chargent puis se déchargent. Cette mesure doit être effectuée durant la période référencée P1 sur la figure 4. Le procédé selon l'invention propose ensuite de faire une seconde mesure à une date t2 correspondant à un régime stabilisé lorsque les capacités sont déchargées. Dans le cas de la figure 4, la tension Vmux est alors proche de zéro.

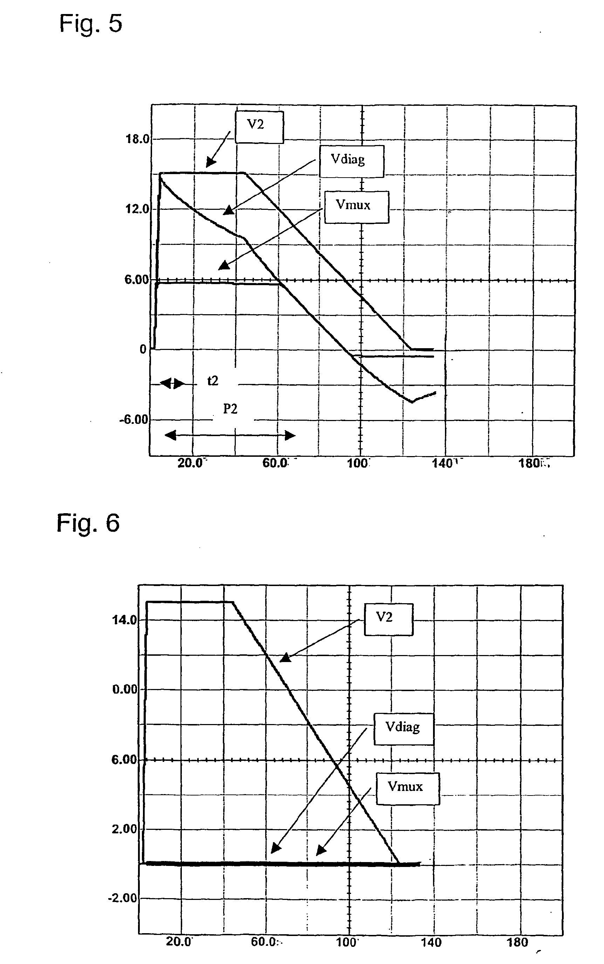

La figure 5 représente les courbes Vdiag, Vmux par rapport à la tension V2 dans le cas de figure où l'antenne n'est pas branchée, ce qui correspond alors au cas où l'on supprimerait tout simplement la bobine 2 sur les figures 1 et 2. Dans ce cas de figure, les trois capacités sont montées en série. Ces capacités se chargent durant le temps de montée du signal V2 puis se déchargent par la résistance R1. On remarque ici que la tension Vmux reste maximale durant toute la largeur d'impulsion. Ici aussi, deux mesures sont effectuées : une première durant le régime transitoire pendant lequel les capacités se chargent puis une seconde mesure en régime stabilisé dans la période d'impulsion. La période P2 symbolisée sur la figure 5 correspond à la période durant laquelle la seconde mesure est réalisée.

Sur la figure 6 enfin on a représenté le cas où une borne de l'antenne est reliée directement par un court-circuit à la masse comme représenté symboliquement sur la figure 1. Dans ce cas, les tensions Vdiag et Vmux restent nulles. Pour les deux mesures effectuées on obtiendra ainsi une tension Vmux nulle.

Comme on peut le remarquer, le fait de prévoir deux mesures, une durant la période transitoire et une ultérieurement, permet de diagnostiquer le cas échéant le défaut de branchement de l'antenne. En effet, lorsque l'antenne est correctement connectée, la tension mesurée à la première mesure présente un niveau élevé et la tension mesurée à la seconde mesure présente un niveau faible. Lorsque l'antenne est déconnectée, la première mesure donne un résultat élevé de même que la seconde mesure. Enfin, lorsqu'un court-circuit à la masse est présent, les deux mesures effectuées donnent un niveau faible. On peut également considérer le cas d'un court-circuit au plus. Dans ce cas, les deux mesures effectuées donnent un niveau élevé, ce qui est donc équivalent au diagnostic d'une antenne absente.

Pour réaliser un bon diagnostic, il faut bien entendu choisir judicieusement les dates auxquelles les mesures sont effectuées. Dans le cas présent, on propose par exemple t1 = 5 ms et t2 = 15 ms. Ces valeurs dépendent bien entendu de la forme du signal V2. La première mesure est effectuée en fin de période de montée ou tout au début de la durée d'impulsion. Dans tous les cas de figure, on remarque qu'à ce moment le régime est transitoire. La seconde mesure est quant à elle effectuée lorsque le régime s'est stabilisé. Cette mesure peut par exemple être effectuée vers le milieu de la durée d'impulsion au cours de laquelle V2 est maximale. Il faut que la seconde mesure soit effectuée après le régime transitoire et ceci dans tous les cas de figure (antenne bien connectée, antenne déconnectée, court-circuit à la masse ou au plus).

Le dispositif de diagnostic décrit ci-dessus utilisé en combinaison avec le procédé décrit permet donc de détecter fiablement un mauvais montage de l'antenne avant l'utilisation de celle-ci. La mesure est effectuée par exemple à la première mise sous tension du circuit. Le diagnostic peut être établi rapidement et à peu de frais.

La présente invention ne se limite pas aux formes de réalisation décrites ci-dessus à titre d'exemples non limitatifs. Elle concerne également toutes les variantes de réalisation à la portée de l'homme du métier dans le cadre des revendications ci-après.

**Revendications**

1.  Procédé de diagnostic concernant la connexion d'une antenne comportant une bobine (2) ou similaire reliée d'une part à un potentiel de référence et d'autre part à une sortie d'un amplificateur (4), un premier condensateur (C2) étant monté en parallèle à la bobine (2) et un second condensateur (C3) étant inséré entre une borne de la bobine (2) et le potentiel de référence,
    le procédé comportant les étapes suivantes :

    a) émission d'un signal par l'amplificateur (4),
    b) première mesure de la tension à une borne de l'antenne durant le régime transitoire provoqué par l'émission du signal, et
    c) seconde mesure de la tension à la même borne de l'antenne en régime stabilisé.

2.  Procédé de diagnostic selon la revendication 1, **caractérisé en ce qu'**il est réalisé à la mise sous tension de l'antenne.

3.  Procédé de diagnostic selon l'une des revendications 1 ou 2, **caractérisé en ce que** le signal émis par l'amplificateur (4) n'est pas modulé.

4.  Procédé de diagnostic selon la revendication 3, **caractérisé en ce que** le signal en sortie d'amplificateur (4) présente un temps de montée puis une durée d'impulsion et enfin un temps de descente.

5.  Procédé de diagnostic selon la revendication 4, **caractérisé en ce que** la première mesure est réalisée durant le temps de montée, par exemple dans la seconde moitié de la montée du signal.

6.  Procédé de diagnostic selon l'une des revendications 4 ou 5, **caractérisé en ce que** la seconde mesure est réalisée au cours de la durée d'impulsion.

7.  Procédé de diagnostic selon l'une des revendications 1 à 6, **caractérisé en ce que** l'antenne est connectée à un étage d'entrée d'un multiplexeur et **en ce qu'**une résistance (R2) disposée entre l'antenne et l'étage d'entrée du multiplexeur limite le courant dans l'étage d'entrée du multiplexeur.

**Claims**

1.  Diagnostic method for an antenna connection comprising a coil (2) or the like, connected on the one hand to a reference potential and on the other to the output from an amplifier (4), a first capacitor (C2) being arranged in parallel to the coil (2) and a second capacitor (C3) being inserted between a terminal of the coil (2) and the reference potential,
    the method comprising the following steps:

    a) the amplifier (4) sends a signal,
    b) first measurement of the voltage on a terminal of the antenna during the transient condition caused by sending the signal, and
    c) second measurement of the voltage on the same antenna terminal in the stable condition.

2.  Diagnostic method according to claim 1,
    **characterised in that**
    it is performed when the antenna is powered up.

3.  Diagnostic method according to one of the claims 1 or 2,
    **characterised in that**
    the signal transmitted by the amplifier (4) is unmodulated.

**4.** Diagnostic method according to claim 3, **characterised in that** the output signal from the amplifier (4) has a rise time followed by a pulse time and then a decay time.

**5.** Diagnostic method according to claim 4, **characterised in that** the first measurement is performed during the rise time, for example in the second half of the signal rise.

**6.** Diagnostic method according to one of the claims 4 or 5, **characterised in that** the second measurement is out during the pulse time.

**7.** Diagnostic method according to one of the claims 1 to 6, **characterised in that** the antenna is connected to an input stage of a multiplexer, and **in that** a resistor (R2) arranged between the antenna and the multiplexer input stage limits the current in the input stage of said multiplexer.

**Patentansprüche**

**1.** Diagnoseverfahren bezogen auf den Anschluss einer Antenne, die eine Spule (2) oder ähnliches aufweist, die einerseits mit einem Referenzpotenzial und andererseits mit einem Ausgang eines Verstärkers (4) verbunden ist, wobei ein erster Kondensator (C2) parallel zur Spule (2) geschaltet ist und ein zweiter Kondensator (C3) zwischen einer Klemme der Spule (2) und dem Referenzpotenzial eingefügt ist, wobei das Verfahren die folgenden Schritte umfasst:

a) Aussenden eines Signals durch den Verstärker (4),
b) erstes Messen der Spannung an einer Klemme der Antenne während des Übergangszustands, der durch Aussenden des Signals hervorgerufen wird, und
c) zweites Messen der Spannung an der gleichen Klemme der Antenne in stabilisiertem Zustand.

**2.** Diagnoseverfahren nach Anspruch 1, **dadurch gekennzeichnet, dass** es durchgeführt wird, wenn die Antenne unter Spannung gesetzt wird.

**3.** Diagnoseverfahren nach Anspruch 1 oder 2, **dadurch gekennzeichnet, dass** das vom Verstärker (4) ausgesandte Signal nicht moduliert ist.

**4.** Diagnoseverfahren nach Anspruch 3, **dadurch gekennzeichnet, dass** das Signal am Ausgang des Verstärkers (4) eine Anstiegzeit, dann eine Impulsdauer und schließlich eine Absenkzeit aufweist.

**5.** Diagnoseverfahren nach Anspruch 4, **dadurch gekennzeichnet, dass** das erste Messen während der Anstiegzeit, zum Beispiel in der zweiten Hälfte des Signalanstiegs, erfolgt.

**6.** Diagnoseverfahren nach Anspruch 4 oder 5, **dadurch gekennzeichnet, dass** das zweite Messen während der Impulsdauer erfolgt.

**7.** Diagnoseverfahren nach einem der Ansprüche 1 bis 6, **dadurch gekennzeichnet, dass** die Antenne mit einer Eingangsstufe einer Antennenweiche verbunden ist, und **dadurch**, dass ein Widerstand (R2) zwischen Antenne und Eingangsstufe der Antennenweiche den Strom in der Eingangsstufe der Antennenweiche begrenzt.

Fig. 1

Fig. 2

Fig. 3

Fig. 4

## Fig. 5

## Fig. 6